# EUROPEAN PATENT SPECIFICATION

(11) **EP 4 014 162 B1**
(45) Date of publication and mention of the grant of the patent: **25.12.2024**
(21) Application number: 20780650.6
(22) Date of filing: 24.09.2020
(51) Int. Cl.: G06V 10/82, G06N 3/08, G06N 3/006, G06F 18/20, G06N 3/044, G06N 3/045

(54) **CONTROLLING AGENTS USING CAUSALLY CORRECT ENVIRONMENT MODELS**
STEUERUNG VON AGENTEN UNTER VERWENDUNG KAUSAL KORREKTER UMGEBUNGSMODELLE
COMMANDE D'AGENTS À L'AIDE DE MODÈLES D'ENVIRONNEMENT CORRECTS DU POINT DE VUE DE LA CAUSALITÉ

(30) Priority: 25.09.2019 US 201962906083 P
(43) Date of publication of application: 22.06.2022
(73) Proprietor: DeepMind Technologies Limited, London EC4A 3TW (GB)
(72) Inventor: DANIHELKA, Ivo, London N1C 4AG (GB); REZENDE, Danilo Jimenez, London N1C 4AG (GB); GREGOR, Karol, London N1C 4AG (GB); PAPAMAKARIOS, Georgios, London N1C 4AG (GB); WEBER, Theophane Guillaume, London N1C 4AG (GB)
(74) Representative: Marks & Clerk GST
(86) International application number: PCT/EP2020/076664
(87) International publication number: WO 2021/058626

(56) References cited:
- ZHIHONG DENG ET AL: "Causal Reinforcement Learning: A Survey", ARXIV.ORG, CORNELL UNIVERSITY LIBRARY, 201 OLIN LIBRARY CORNELL UNIVERSITY ITHACA, NY 14853, 4 July 2023 (2023-07-04), XP091555115
- AMY ZHANG ET AL: "Learning Causal State Representations of Partially Observable Environments", ARXIV.ORG, CORNELL UNIVERSITY LIBRARY, 201 OLIN LIBRARY CORNELL UNIVERSITY ITHACA, NY 14853, 25 June 2019 (2019-06-25), XP081384043
- PABLO HERNANDEZ-LEAL ET AL: "A Survey of Learning in Multiagent Environments: Dealing with Non-Stationarity", ARXIV.ORG, CORNELL UNIVERSITY LIBRARY, 201 OLIN LIBRARY CORNELL UNIVERSITY ITHACA, NY 14853, 28 July 2017 (2017-07-28), XP081126989
- DANILO J REZENDE ET AL: "Causally Correct Partial Models for Reinforcement Learning", ARXIV.ORG, CORNELL UNIVERSITY LIBRARY, 201 OLIN LIBRARY CORNELL UNIVERSITY ITHACA, NY 14853, 7 February 2020 (2020-02-07), XP081594055
- LARS BUESING ET AL: "Woulda, Coulda, Shoulda: Counterfactually-Guided Policy Search", ARXIV.ORG, CORNELL UNIVERSITY LIBRARY, 201 OLIN LIBRARY CORNELL UNIVERSITY ITHACA, NY 14853, 15 November 2018 (2018-11-15), XP080944803

## Description

### CROSS-REFERENCE TO RELATED APPLICATION

This application claims priority to U.S. Provisional Application No. 62/906,083, filed on September 25, 2019.

### BACKGROUND

This specification relates to reinforcement learning.

In a reinforcement learning system, an agent interacts with an environment by performing actions that are selected by the reinforcement learning system in response to receiving observations that characterize the current state of the environment.

Some reinforcement learning systems select the action to be performed by the agent in response to receiving a given observation in accordance with an output of a neural network.

Neural networks are machine learning models that employ one or more layers of nonlinear units to predict an output for a received input. Some neural networks are deep neural networks that include one or more hidden layers in addition to an output layer. The output of each hidden layer is used as input to the next layer in the network, i.e., the next hidden layer or the output layer. Each layer of the network generates an output from a received input in accordance with current values of a respective set of parameters. Examples of relevant prior art are: AMY ZHANG ET AL: "Learning Causal State Representations of Partially Observable Environments",ARXIV.ORG, CORNELL UNIVERSITY LIBRARY, 201 OLIN LIBRARY CORNELL UNIVERSITY ITHACA, NY 14853, 25 June 2019 (2019-06-25), XP081384043, and LARS BUESING ET AL: "Woulda, Coulda, Shoulda: Counterfactually-Guided Policy Search", ARXIV.ORG, CORNELL UNIVERSITY LIBRARY, 201 OLIN LIBRARY CORNELL UNIVERSITY ITHACA, NY 14853, 15 November 2018 (2018-11-15), XP080944803.

### SUMMARY

This specification describes a reinforcement learning system that controls an agent interacting with an environment by, at each of multiple time steps, processing data characterizing the current state of the environment at the time step (i.e., an "observation") to select an action to be performed by the agent from a set of actions.

At each time step, the state of the environment at the time step depends on the state of the environment at the previous time step and the action performed by the agent at the previous time step.

A model of the environment may be constructed such that the environment model is causally correct. The environment model may be used in a reinforcement learning system as part of a planning subsystem for determining actions for the agent to perform, for example, to achieve a particular task or goal. Generally, such a system may receive the current observation and performs a plurality of planning iterations. The system then selects the action to be performed in response to the current observation based on the results of the planning iterations. At each planning iteration, the system may generate a sequence of actions that progress the environment to new states starting from the state represented by the current observation.

Unlike conventional systems, the system does not require performing the planning iterations using a full simulator of the environment, i.e., does not use a simulator of the environment to determine which state the environment will transition into as a result of a given action being performed in a given state. Instead, the system uses an environment model that is configured to receive an input action selected from the set of actions and to update its hidden state to simulate a predicted next environment state that the environment would transition into if the agent performed the input action when the environment is in the input environment state. That is, the environment model does not need to model the environment fully, only the necessary parts that have an influence on planning whilst still fulfilling the condition of causal correctness. Each hidden state may be a lower-dimensional representation of an observation tThe environment model is configured to update its hidden state based on a latent representation computed from the hidden state. The updating may not require processing an observation of an environment state. Thus, the system can perform planning using only these hidden states without ever being required to reconstruct the full state of the environment or even a full observation characterizing a state.

According to an aspect, there is provided a computer-implemented method of using an environment model to simulate state transitions of an environment being interacted with by an agent that is controlled using a policy neural network. The policy neural network is configured to receive an observation characterizing a state of the environment, update a belief representation of the state of the environment, generate a latent representation from the belief representation, and generate an output specifying an action to be performed by the agent from the latent representation. The method comprises initializing an internal representation of a state of the environment at a current time point. The method further comprises repeatedly performing the following operations: receiving an action to be performed by the agent; generating, based on the internal representation, a predicted latent representation that is a prediction of a latent representation that would have been generated by the policy neural network by processing an observation characterizing the state of the environment corresponding to the internal representation; and updating the internal representation to simulate a state transition caused by the agent performing the received action by processing the predicted latent representation and the received action using the environment model.

The use of an intermediate latent representation between the belief representation and the action output in the policy neural network and the use of a predicted latent representation by the environment model ensures casual correctness as the latent representation provides a variable to block the influence of confounding variables that may arise if the environment model does not capture all aspects of the environment. Given the latent representation, the action performed by an agent is conditionally independent of the state.

The method may further comprise generating, from the internal representation of the state of the environment, a target to be provided for use in controlling the agent. The target may be a reward and/or an expected return.

The method comprises based on a result of repeatedly performing the operations, an action to be performed by the agent in the environment at the current time point. The target may be used in selecting an action for the agent to perform. The method may further comprise controlling the agent to perform the selected action.

Initializing an internal representation of a state of the environment at a current time point may comprise receiving, by the policy neural network, an observation characterizing the state of the environment at the current time point. The initializing may further comprise updating, by the policy neural network and based on processing the received observation, a belief representation of the state of the environment. The initializing may further comprise initializing the internal representation based on the belief representation of the state of the environment.

Updating the internal representation may not include processing the observation to be provided to the policy neural network that characterizes the state of the environment. Updating the internal representation may be based upon the initial representation of a state of the environment, one or more past actions and the received action. For example, the updating may not require processing of past states of the internal representation caused by the past actions. As such, updating the internal representation may be based upon the initial representation of a state of the environment, one or more past actions and the received action only.

The method may further comprise processing, by the policy neural network, the belief representation of the state of the environment and the action that is performed by the agent to update the belief representation of the state of the environment at a future time point that is after the current time point. Updating the belief representation of the state of the environment at the future time point may further comprise processing an observation that characterizes the state of the environment at the future time point.

The latent representation may correspond to one or more layers of the policy neural network after updating the belief representation of the state of the environment. The one or more layers may comprise an input layer of the policy neural network after updating the belief representation of the state of the environment. The belief representation may be an internal state of the policy neural network.

The latent representation may correspond to respective probabilities generated by the policy neural network for controlling the agent to perform different actions.

The latent representation may correspond to an intended action to be performed by the agent before selecting actions under exploration. That is, an exploration technique, such as epsilon-greedy exploration, may be used to change an intended action to a different action in order to cause the agent to explore other actions to gain more information regarding the environment. Thus, the executed action may be different from the intended action in this regard. The policy neural network may be recurrent neural network. It will be appreciated that the policy neural network has a plurality of network parameters.

The environment model may comprise a neural network having a plurality of network parameters. The environment model may comprise a recurrent neural network. The environment model may further comprise a generative model conditioned on the states of the recurrent neural network to generate the target to be provided for use in controlling the agent. The generative model may comprise one or more neural network layers.

The environment specified in the latent representation of the state of the environment may correspond to a partial view of the environment being interacted with by the agent. For example, a partial view may comprise a subset of the full data characterizing the environment. The partial view may be based upon past observations and/or past actions.

Generating the latent representation from the belief representation may comprise sampling from a distribution of a plurality of variables that describe the latent representation, the distribution being generated by the policy neural network and being conditioned on the belief representation. Generating the predicted latent representation that is a prediction of the latent representation may comprise sampling from a distribution of a plurality of variables that describe the latent representation, the distribution being generated by the environment model and being conditioned on the internal representation.

The method may further comprise iteratively training the environment model on training data to determine trained values of the model parameters, wherein the training data includes observation received by the agent during interaction with the environment.

Training the environment model may comprise, at each training iteration generating, by the environment model, a training predicted latent representation; evaluating an objective function measuring a difference between the training predicted latent representation and the actual latent representation that is generated by the policy neural network; and updating, based on a computed gradient of the objective function, corresponding values of the environment model parameters.

According to another aspect, there is provided a system comprising one or more computers and one or more storage devices storing instructions that are operable, when executed by the one or more computers, to cause the one or more computers to perform the operations of the above method aspect.

According to a further aspect, there is provided a computer storage medium encoded with instructions that, when executed by one or more computers, cause the one or more computers to perform the operations of the method aspect.

It will be appreciated that features described in the context of one aspect may be combined with features described in the context of another aspect.

Particular embodiments of the subject matter described in this specification can be implemented so as to realize one or more of the following advantages.

Oftentimes, when predicting state transitions of an environment that is being interacted with by the agent, an environment model fails to make correct predictions due to issues related to incorrect causal reasoning. That is, the environment model incorrectly attributes at least part of a reward received by the agent to an action that is performed by the agent.

The techniques described in this specification, however, provide the environment model with additional information derived from latent representations that corresponds to frontdoor or backdoor variables in causal reasoning (see Pearl et al., Causal inference in statistics: A primer. John Wiley & Sons, 2016.

This allows the environment model to generate simulations that are causally correct and are robust to changes in the policy that is being followed in selecting actions to be performed by the agent. This improves the effectiveness of the reinforcement learning algorithm and can avoid dangerous or otherwise risky situations that would otherwise result from the environment model not accurately accounting for stochasticity or other external factors within the environment. As one example, the techniques allow for the system to control an agent navigating through an environment to avoid taking a path with promising immediate rewards but substantially negative punishments in the long run.

In addition, the techniques prevent the environment model from being unrealistically optimistic about the environment, especially when simulating target rewards to be received by the agent, which in turn results in improved performance of the policy neural network when used in selecting actions to be performed by the agent.

In some implementations, the techniques use an environment model to simulate environments that correspond to a partial view of the entire environment. Such partial models are neither conditioned on, nor configured to generate the full set of observable data (which is typically very high dimensional) to be provided to the agent. For example, the observable data may include images of the environment. Conditioning the environment model based upon the image data may require modeling and generating images. Given the high-dimensionality of image data, such modeling is computationally expensive and may be intractable. In addition, the modeling may capture aspects of visual details that are unnecessary for the purposes of action planning. However, simply choosing not to model certain aspects of the environment may cause the environment model to be causally incorrect as the unmodelled aspects may become confounding variables. This may result in suboptimal actions being taken by the agent. Therefore, controlling an agent using a casually correct partial view environment model as described herein is able to achieve a high level of accuracy in simulating (at least a partial view of) the environment while requiring less computational resources (e.g., memory, computing power, or both) than systems that are required to predict high-dimensional observations in order to perform planning.

The details of one or more embodiments of the subject matter described in this specification are set forth in the accompanying drawings and the description below. Other features, aspects, and advantages of the subject matter will become apparent from the description, the drawings, and the claims.

### BRIEF DESCRIPTION OF THE DRAWINGS

FIG. 1 shows an example reinforcement learning system.
FIG. 2 is an example illustration of dynamics of an environment being interacted with by a reinforcement learning agent.
FIG. 3 is a flow diagram of an example process for simulating state transitions of an environment.

Like reference numbers and designations in the various drawings indicate like elements.

### DETAILED DESCRIPTION

This specification describes a reinforcement learning system that controls an agent interacting with an environment by, at each of multiple time steps, processing data characterizing the current state of the environment at the time step (i.e., an "observation") to select an action to be performed by the agent.

At each time step, the state of the environment at the time step depends on the state of the environment at the previous time step and the action performed by the agent at the previous time step.

The environment is a real-world environment and the agent is a mechanical agent interacting with the real-world environment, e.g., a robot or an autonomous or semi-autonomous land, air, or sea vehicle navigating through the environment.

In these implementations, the observations may include, e.g., one or more of: images, object position data, and sensor data to capture observations as the agent as it interacts with the environment, for example sensor data from an image, distance, or position sensor or from an actuator.

For example in the case of a robot the observations may include data characterizing the current state of the robot, e.g., one or more of: joint position, joint velocity, joint force, torque or acceleration, e.g., gravity-compensated torque feedback, and global or relative pose of an item held by the robot.

In the case of a robot or other mechanical agent or vehicle the observations may similarly include one or more of the position, linear or angular velocity, force, torque or acceleration, and global or relative pose of one or more parts of the agent. The observations may be defined in 1, 2 or 3 dimensions, and may be absolute and/or relative observations.

The observations may also include, for example, sensed electronic signals such as motor current or a temperature signal; and/or image or video data for example from a camera or a LIDAR sensor, e.g., data from sensors of the agent or data from sensors that are located separately from the agent in the environment.

In the case of an electronic agent the observations may include data from one or more sensors monitoring part of a plant or service facility such as current, voltage, power, temperature and other sensors and/or electronic signals representing the functioning of electronic and/or mechanical items of equipment.

In these implementations, the actions may be control inputs to control the robot, e.g., torques for the joints of the robot or higher-level control commands, or the autonomous or semi-autonomous land, air, sea vehicle, e.g., torques to the control surface or other control elements of the vehicle or higher-level control commands.

In other words, the actions can include for example, position, velocity, or force/torque/acceleration data for one or more joints of a robot or parts of another mechanical agent. Action data may additionally or alternatively include electronic control data such as motor control data, or more generally data for controlling one or more electronic devices within the environment the control of which has an effect on the observed state of the environment. For example in the case of an autonomous or semi-autonomous land or air or sea vehicle the actions may include actions to control navigation e.g. steering, and movement e.g., braking and/or acceleration of the vehicle.

In some implementations the environment is a simulated environment and the agent is implemented as one or more computers interacting with the simulated environment. Training an agent in a simulated environment may enable the agent to learn from large amounts of simulated training data while avoiding risks associated with training the agent in a real world environment, e.g., damage to the agent due to performing poorly chosen actions. An agent trained in a simulated environment may thereafter be deployed in a real-world environment.

The simulated environment may be a motion simulation environment, e.g., a driving simulation or a flight simulation, and the agent may be a simulated vehicle navigating through the motion simulation. In these implementations, the actions may be control inputs to control the simulated user or simulated vehicle.

In another example, the simulated environment may be a video game and the agent may be a simulated user playing the video game. Generally, in the case of a simulated environment, the observations may include simulated versions of one or more of the previously described observations or types of observations and the actions may include simulated versions of one or more of the previously described actions or types of actions.

In a further example the environment may be a chemical synthesis or a protein folding environment such that each state is a respective state of a protein chain or of one or more intermediates or precursor chemicals and the agent is a computer system for determining how to fold the protein chain or synthesize the chemical. In this example, the actions are possible folding actions for folding the protein chain or actions for assembling precursor chemicals/intermediates and the result to be achieved may include, e.g., folding the protein so that the protein is stable and so that it achieves a particular biological function or providing a valid synthetic route for the chemical. As another example, the agent may be a mechanical agent that performs or controls the protein folding actions selected by the system automatically without human interaction. The observations may include direct or indirect observations of a state of the protein and/or may be derived from simulation.

In a similar way the environment may be a drug design environment such that each state is a respective state of a potential pharma chemical drug and the agent is a computer system for determining elements of the pharma chemical drug and/or a synthetic pathway for the pharma chemical drug. The drug/synthesis may be designed based on a reward derived from a target for the drug, for example in simulation. As another example, the agent may be a mechanical agent that performs or controls synthesis of the drug.

In some applications the agent may be a static or mobile software agent i.e. a computer programs configured to operate autonomously and/or with other software agents or people to perform a task. For example the environment may be an integrated circuit routing environment and the system may be configured to learn to perform a routing task for routing interconnection lines of an integrated circuit such as an ASIC. The rewards (or costs) may then be dependent on one or more routing metrics such as an interconnect resistance, capacitance, impedance, loss, speed or propagation delay, physical line parameters such as width, thickness or geometry, and design rules. The observations may be observations of component positions and interconnections; the actions may comprise component placing actions e.g. to define a component position or orientation and/or interconnect routing actions e.g. interconnect selection and/or placement actions. The routing task may thus comprise placing components i.e. determining positions and/or orientations of components of the integrated circuit, and/or determining a routing of interconnections between the components. Once the routing task has been completed an integrated circuit, e.g. ASIC, may be fabricated according to the determined placement and/or routing. Or the environment may be a data packet communications network environment, and the agent be a router to route packets of data over the communications network based on observations of the network.

Generally, in the case of a simulated environment, the observations may include simulated versions of one or more of the previously described observations or types of observations and the actions may include simulated versions of one or more of the previously described actions or types of actions.

In some other applications the agent may control actions in a real-world environment including items of equipment, for example in a data center, in a power/water distribution system, or in a manufacturing plant or service facility. The observations may then relate to operation of the plant or facility. For example the observations may include observations of power or water usage by equipment, or observations of power generation or distribution control, or observations of usage of a resource or of waste production. The actions may include actions controlling or imposing operating conditions on items of equipment of the plant/facility, and/or actions that result in changes to settings in the operation of the plant/facility e.g. to adjust or turn on/off components of the plant/facility.

In some further applications, the environment is a real-world environment and the agent manages distribution of tasks across computing resources e.g. on a mobile device and/or in a data center. In these implementations, the actions may include assigning tasks to particular computing resources.

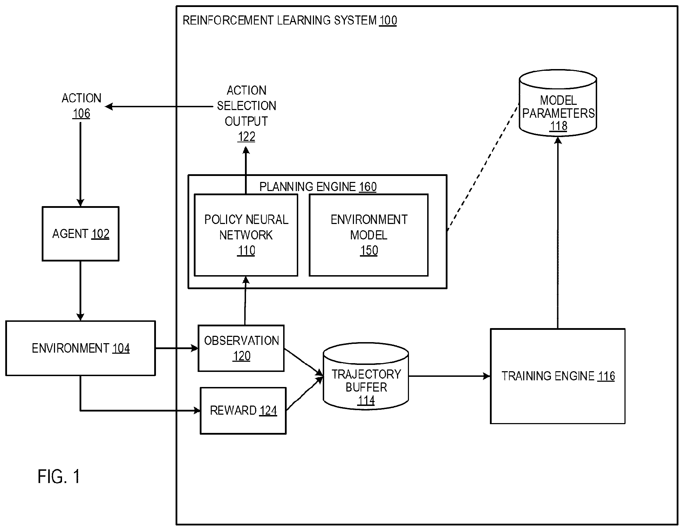

FIG. 1 shows an example reinforcement learning system 100. The reinforcement learning system 100 is an example of a system implemented as computer programs on one or more computers in one or more locations in which the systems, components, and techniques described below are implemented.

The system 100 controls an agent 102 interacting with an environment 104 by using a planning engine 160 which in turn includes a policy neural network 110 and an environment model 150 to select actions 106 to be performed by the agent 102 that cause the state of the environment to transition into new states.

The system 100 includes the planning engine 160 and a set of model parameters 118 for the components of the planning engine 160, including parameters of the policy neural network 110 and parameters of the environment model 150. The system 100 may also include a training engine 116.

Briefly, the environment model 150 is a model which, given information at a given time step, is able to make a prediction about at least one future time. As will be described in more detail below, the environment model 150 is used in the system 100 to make a prediction about multiple time steps after the given time step. This is referred to as a rollout. It represents an imagined trajectory of the environment at times after the given time step, assuming that the agent performs certain actions.

At each of the multiple time steps, the policy neural network 110 is configured to process an input that includes the current observation 120 characterizing the current state of the environment 104 in accordance with the model parameters 118 to generate an action selection output 122 ("action selection policy") that could be used to control the agent.

For example, the policy neural network 110 can be a recurrent neural network, e.g., a LSTM network, that can receive an input including an observation of the environment and to process the input in accordance with a set of policy neural network parameters to generate an action selection output 122 that can be used to determine an action 106 to be performed by the agent 102 at each of multiple time steps.

A few examples of the action selection output 122 are described next.

In one example, the action selection output 122 may include a respective numerical probability value for each action in a set of possible actions that can be performed by the agent. If being used to control the agent, the system 100 could select the action to be performed by the agent, e.g., by sampling an action in accordance with the probability values for the actions, or by selecting the action with the highest probability value.

In another example, the action selection output 122 may directly define the action to be performed by the agent, e.g., by defining the values of torques that should be applied to the joints of a robotic agent.

In another example, the action selection output 122 may include a respective Q-value for each action in the set of possible actions that can be performed by the agent. If being used to directly control the agent, the system 100 could process the Q-values (e.g., using a soft-max function) to generate a respective probability value for each possible action, which can be used to select the action to be performed by the agent (as described earlier). The system 100 could also select the action with the highest Q-value as the action to be performed by the agent.

The Q value for an action is an estimate of a "return" that would result from the agent performing the action in response to the current observation 120 and thereafter selecting future actions performed by the agent 102 in accordance with current values of the policy neural network parameters.

A return refers to a cumulative measure of "rewards" 124 received by the agent, for example, a time-discounted sum of rewards. The agent can receive a respective reward 124 at each time step, where the reward 124 is specified by a scalar numerical value and characterizes, e.g., a progress of the agent towards completing an assigned task.

Rather than directly using the policy neural network 110 to control the agent 106, however, the system 100 instead uses the environment model 150 to perform a plurality of planning iterations. The system then selects the action 106 to be performed in response to the current observation based on the results of the planning iterations. At each planning iteration, the system 100 can generate a sequence of actions 106 that progress the environment 104 to new states starting from the state represented by the current observation 120. Typically the environment model 150 is used to produce multiple trajectories starting from the current observation 120. This can aid in determining more effective action selection policies to maximize expected cumulative reward for the agent 102.

Specifically, the system 100 can use the environment model 150 together with an MDP-based planning algorithm, e.g., a tree-based search or other look-ahead planning methods, to achieve high quality agent performance in a range of challenging and visually complex domains, without any knowledge of their underlying dynamics. For example, the MDP-based planning algorithm may be a Monte Carlo tree search (MCTS) algorithm. At each time step, the system 100 makes use of an action selection policy, the reward estimate, and, when relevant, the value estimate generated by the environment model in accordance with current model parameters. Each value estimate, when considered, specifies a value of the environment being in the predicted next environment state to performing the task. The system runs the MCTS algorithm using these data to determine an action selection output and, in some cases, an estimated value, based on which a next action to be performed by the agent can be selected.

Examples of trajectory planning over a series of internal planning iterations and how to use planning iterations to control an agent are described in Hafner et al.. Learning latent dynamics for planning from pixels. arXiv:1811.04551, 2018, and in Schrittwieser et al. Mastering Atari, go, chess and shogi by planning with a learned model. arXiv:1911.08265, 2019.

More specifically, the environment model 150 can first be initialized using an initial action, e.g., a candidate action selected by the system for a given state of the environment according to a currently adopted action selection policy, and an initial hidden state of the policy neural network 110. To perform a rollout of multiple state transitions forward from the given state of the environment, the environment model 150 is then configured to receive, over multiple time steps, actions to be performed by the agent and generates as output respective targets (e.g., in terms of rewards to be received by the agent at each of multiple time steps) for each of the multiple trajectories starting from the given environment state that the system 100 can provide to the policy neural network 110. The system 100 then uses these targets to select action to be performed by the agent 102.

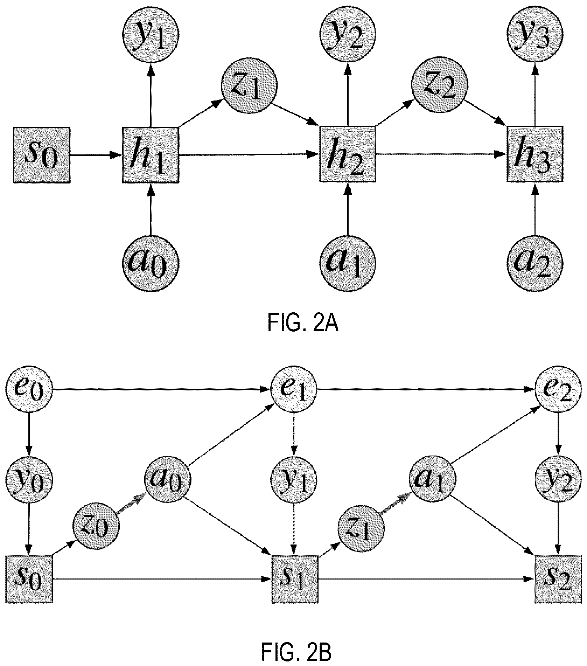

Simulating state transitions of the environment being interacted with by the agent using the environment model 150 is described in more detail below with reference to FIGS. 2-3.

The exact architectures of the environment model 150 may vary, but typically, the environment model 150 can be a recurrent neural network that is configured to receive as input an action performed by the agent and to process the input in accordance with a set of environment model parameters to generate as output a target (e.g., in terms of rewards to be received by the agent as a result of performing the action) and to update its hidden state to simulate a state transition of the environment caused by the action. For example, the architecture of the environment model 150 may include a sequence of one or more layers (e.g., convolutional layers or fully-connected layers), followed by one or more recurrent layers (e.g., long short-term memory (LSTM) layers) and an output layer that generates the environment model output including the observation.

Because the environment model 150 is specifically configured to predict target rewards for use in action selection, i.e., instead of a full set of observable data that characterizes the entire environment, it may be referred to as a partial environment model. The output data of the environment model generally has lower dimension, simpler modality, or both than the actual observation data that could have been received by the system during the interaction of the agent with the environment.

FIG. 2 is an example illustration of dynamics of an environment being interacted with by a reinforcement learning agent. The environment is modeled using multiple states *eₜ* that can each transition into a subsequent state *e*_{*t*+1} in accordance with a transition probability of form *p*(*e*_{*t*+1}|*eₜ, aₜ*).

In the example of FIG. 2A, at each step t, the system can use the environment model 150 to output a current target *yₜ* (e.g., in terms of rewards to be received by the agent), sample a latent representation *zₜ* from a given distribution *p*(*zₜ*|*hₜ*) that is conditioned on the current hidden state *hₜ* of the environment model (which corresponds to an "internal representation" of a state of the environment *eₜ*.), select an action *aₜ* according to a given action selection policy and based on the current hidden state *hₜ* and on the sampled latent representation *zₜ,* and determine an updated environment model hidden state *h*_{*t*+1} using (i) the current environment model hidden state *hₜ,* (ii) the current latent representation *zₜ*, and (iii) the selected action *aₜ.* Specifically, the selected action corresponds to the current action to be performed by the agent at the current step which can cause the environment to transition into a subsequent state.

In particular, the given distribution *p*(*zₜ*|*hₜ*) can be parameterized by the output of a given layer, e.g., an input layer or an intermediate layer, of the environment model 150 or a combination of the outputs of multiple layers of the environment model 150.

The latent representation *zₜ* sampled from *p*(*zₜ*|*hₜ*) will be referred to as a predicted latent representation of a state of the environment computed by the environment model, i.e., a prediction of a target latent representation that would have been derived from a hidden state of the policy neural network 110 based on using the policy neural network to process a policy network input including an observation characterizing the state of the environment. Deriving the target latent representation from the policy neural network hidden states is described in more detail below.

FIG. 2B shows an example of selecting actions to be performed by the agent using the policy neural network 110. In the example of FIG. 2B, at each time step *t,* the policy neural network 110 receives an observation *yₜ* and processes the observation to update its hidden state *sₜ* (which corresponds to a "belief representation" of a state of the environment *eₜ*) from which a latent representation *zₜ* can be derived, and to generate an action selection output π(*aₜ*|*zₜ*) that is conditioned on the latent representation *zₜ*. The system can then cause the agent to interact with the environment by taking an action *aₜ* according to the action selection output at the current time step, e.g., by passing a control signal to a control system for the agent,.

Computing the latent representation *zₜ* usually involves sampling from a given distribution *m*(*zₜ*|*sₜ*) that is conditioned on a hidden state of the policy neural network 110. Similarly, the given distribution *m*(*zₜ*|*sₜ*) can be parameterized by the output of a given layer, e.g., an output layer or an intermediate layer preceded by the one or more recurrent layers, of the policy neural network 110 or a combination of the outputs of multiple layers of the policy neural network 110. In some implementations, each such output is generated by the policy neural network based on its current hidden state. For example, the policy neural network 110 generates, at a given layer and for each of one or more pre-defined latent factors, an output that parameterizes a distribution, e.g., a Gaussian distribution, over a set of possible values for the latent factor. The system can then sample a value for each latent factor from the distribution.

For example, the hidden states of the policy neural network can be used as parameterizing the distribution *m*(*zₜ*|*sₜ*) from which the latent representation *zₜ* is determined. Each hidden state is generally defined by an ordered collection of numeric values that has a fixed number of values.

As another example, the action selection probabilities can be used as parameterizing the distribution *m*(*zₜ*|*sₜ*) from which the latent representation *zₜ* is determined. For example, in cases where the action selection output includes a respective numerical probability value for each action in a discrete set of possible actions, the latent representation *zₜ* can be a concatenated representation, e.g., a vector, of the probabilities specified by the action selection outputs. Alternatively, the latent representation *zₜ* can be the actual action identified by the action selection output (i.e., the action assigned with the highest probability or an action sampled from the probability distribution) without applying any exploration policy, e.g., ε-greedy exploration policy.

The training engine 116 trains the policy neural network 110 and the environment model 150 by using a reinforcement learning technique to iteratively adjust the values of the set of parameters of the policy neural network 110 and the environment model 150 based on the interactions of the agent with the environment. An example of a suitable reinforcement learning technique is described in Espeholt, Lasse, et al. "IMPALA: Scalable Distributed Deep-RL with Importance Weighted Actor-Learner Architectures." ICML. 2018.

In particular, during training, trajectories generated as a result of the agent interacting with the environment are stored in a trajectory buffer 114. Each trajectory can include (i) a sequence of observations y received by the agent that characterize respective states of the environment and that specify respective rewards issued to the agent by the environment and (ii) a sequence of actions *a* performed by the agent in response to the observations.

The training engine 116 updates the parameters of the policy neural network 110 to encourage it to generate policy outputs that maximize the expected cumulative reward received by the system 100. The training engine 116 updates the model parameters of the environment model 150 to encourage it to more accurately simulate state transitions of the environment caused by the actions that would be performed by the agent including predicting accurate target rewards for these actions. More specifically, the training engine 116 can encourage the environment model 150 to generate predicted latent representations that emulate the actual latent representations generated by the policy neural network. For example, at each of training iteration: the training engine 116 can use the environment model 150 to generate a training predicted latent representation for a state of the environment, evaluate an objective function measuring a difference between the training predicted latent representation and the actual latent representation that is generated by the policy neural network 110 for the same state of the environment, and determine an update to current values of the environment model parameters based on a computed gradient of the objective function.

Training the environment model 150 together with the policy neural network 150 on the trajectory data tunes the values of the set of parameters of the policy neural network 110 to cause the policy neural network 110 to derive more useful information from the observations 120 which aid in causal reasoning of state transitions within the environment and long-term trajectory planning and cause the policy neural network 110 to determine more effective policy outputs to maximize expected cumulative reward, e.g., a long-term time-discounted sum of rewards received by the system 100, even when the observations 120 do not accurately account for stochasticity or other external factors within the environment 104.

Once trained, the system 100 can be used, for example, to select actions 106 to be performed by the agent 102. For example, if the reward 124 includes a value rating the success of the interaction of the agent 102 with the environment 104, e.g. a value representing the amount of time it takes for the agent to accomplish a task starting from a current state of the environment, then the action 106 of the agent 102 may be selected as an action that that is predicted by the system 100, i.e., as a result of the multiple planning iterations, to optimize the component of the reward 124 corresponding to the value.

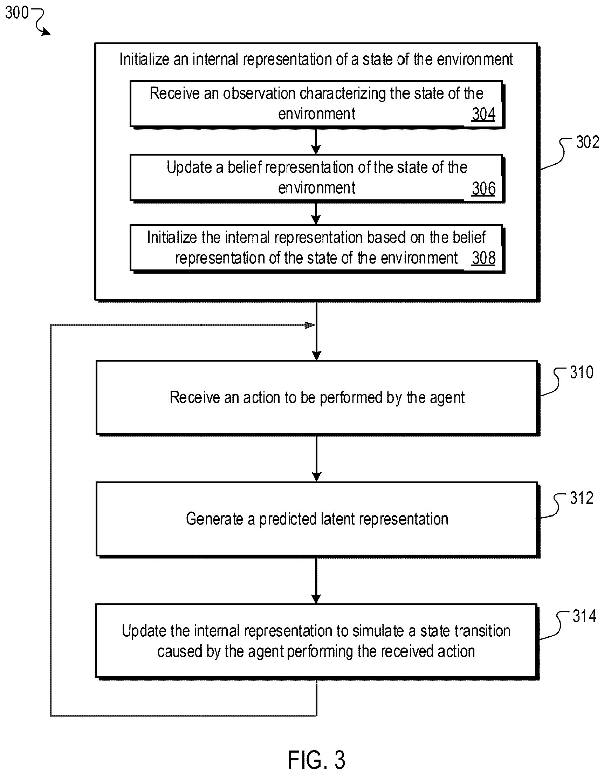

FIG. 3 is a flow diagram of an example process 300 for simulating state transitions of an environment. For convenience, the process 300 will be described as being performed by a system of one or more computers located in one or more locations. For example, a reinforcement learning system, e.g., the reinforcement learning system 100 of FIG. 1, appropriately programmed, can perform the process 300.

The system can repeatedly perform the process 300 to generate multiple trajectories including simulated state transitions caused by actions that would be performed by the agent that, for example, can be used as training data for the system.

The system initializes a hidden state of the environment model (302). In general, each hidden state of the environment model can be generated from processing (i) the preceding environment model hidden state *h*_{*t*-1}*,* (ii) the preceding latent representation *z*_{*t*-1}, and (iii) the preceding action *a*_{*t*-1} that has been previously performed by the agent in the trajectory. Thus hidden state captures information determined (or understood) by the environment model for the environment at a corresponding state of the environment.

If the action is the first action in the trajectory, the corresponding hidden state can be an initial hidden state computed by performing the following steps 304-308.

The system receives, an observation characterizing the state of the environment at the current time point (304). The observation can be a first observation in the sequence of observations included in the trajectory.

The system updates a hidden state of the policy neural network (306). That is, the system uses the policy neural network to process a policy network input including the received first observation to determine the initial policy network hidden state, and to output an action selection output *ψ*(*a*₀|*s*₀) that the system can use to select a first action *a*₀ to be performed by the agent at the beginning of the trajectory.

The system initializes the environment model hidden state based on the initial hidden state of the policy neural network and on the selected first action (308). For example, referring back to the example of FIG. 2A, the system can evaluate a predetermined initialization function *h*₁ *= g*(*s*₀*, a*₀) using the initial policy network hidden state and the action to determine an output that the system can use as the initial hidden state of the environment model.

The system then repeatedly performs the steps 310-314 of the process 300 to simulate a plurality of state transitions within the environment. In other words, the system performs steps 310-314 at each of multiple future trajectory steps forward from the first step. For convenience, each of the steps 310-314 will be described as being performed at a "current" trajectory step.

The system receives an action to be performed by the agent (310) at the current trajectory step. In general, the action can be an arbitrary action that has been selected, by using the policy neural network or another action selection component of the system implementing any of a variety of action selection policies.

For example, the system can select, according to a given action selection policy and based on a predicted latent representation (as generated at step 312) and, optionally, the environment model hidden state, the action to be performed by the agent.

The system generates a predicted latent representation (312) based on the current hidden state of the environment model. The predicted latent representation *zₜ* is a prediction of a latent representation that would have been generated by using the policy neural network to process a policy network input including an observation characterizing the state of the environment that corresponds to the current environment model hidden state. In particular, the system can generate the predicted latent representation *zₜ,* which can take any of a variety of forms as described above, by sampling from a given distribution *p*(*zₜ*|*hₜ*) that is conditioned on the current environment model hidden state *hₜ.*

Optionally, the system also uses the environment model to output a current target *yₜ* based on the current hidden state *hₜ* that the system can use in action selection during planning. That is, the target is conditioned on the current environment model hidden state *hₜ.* The exact format of the targets depend on actual choice of the planning algorithm and thus may vary, but typically, the target specifies a reward that the system can use in action selection starting from the first trajectory step.

The system updates the environment model hidden state (314) to simulate a state transition caused by the agent performing the received action. The system can determine the update to the current environment model hidden state, i.e., modify the current hidden state of the environment model to transition into a subsequent hidden state, by processing (i) the current environment model hidden state *hₜ,* (ii) the predicted latent representation *zₜ,* and (iii) the received action *aₜ* using the environment model and in accordance with current values of the environment model parameters.

Unlike conventional RL planning techniques, e.g., action-conditional prediction using an autoregressive generative model or option-conditional prediction using a value prediction network, which can predict outcomes of a sequence of actions on the environment in an overly redundant or causally incorrect manner, simulating state transitions caused by the agent performing various action as described above is only conditioned on, and therefore dependent upon, an minimally required amount of information to ensure causal correctness. In particular, the system can update the environment model hidden state by conditioning on the action and the minimally required amount of information to reproduce the action distribution in the model training data. Given such information, the action is independent of the other inputs and thus the model becomes less likely to be confounded by any information within the observations that aren't considered, or accounted for, by the environment model when simulating the actual, e.g., real-world, environment. By using such environment model, the system can simulate causally correct state transitions while being less affected by changes to the action selection policy and, when used in training the policy neural network, can assist in the learning of an optimal action selection policy that the system can use in controlling the agent to maximize an expected cumulative reward received by the agent by learning robust and causally correct action selection policies.

An example algorithm for using the environment model to generate a simulated trajectory under a given action selection policy ψ is shown below.

| | |
|---|---|
| Require an agent state: *s*₀ | |
| *a*₀ = *ψ*(*a*₀\|*s*₀) ... choose the first action | |
| *h*₁ *= g*(*s*₀*, a*₀) ... initialize the model state | |
| For each trajectory step: | |
| | Predict the wanted targets *p*(*yₜ*\|*hₜ*) (e.g., rewards, returns, ...). |
| | *zₜ* ~ *p*(*zₜ*\|*hₜ*) ... sample the partial view |
| | *aₜ* ~ *ψ*(*aₜ*\|*hₜ, zₜ*) ... choose the next action |
| | *h*_{*t*+1} = RNN*ₕ*(*hₜ*, *zₜ*, *aₜ*) ... update the model state |

In the example algorithm shown above, at each trajectory step, the system uses the environment model to determine a current target *yₜ* ("wanted targets") for use in planning. In this example, the action to be performed by the agent is selected according to the action selection policy ψ, where the policy relies upon both the current hidden state of the environment model and the predicted latent representation when used in selecting the actions. In particular, the system determines the predicted latent representation *zₜ* ("partial view") by sampling from the distribution *p*(*zₜ*|*hₜ*) that is conditioned on the current hidden state of the environment model.

This specification uses the term "configured" in connection with systems and computer program components. For a system of one or more computers to be configured to perform particular operations or actions means that the system has installed on it software, firmware, hardware, or a combination of them that in operation cause the system to perform the operations or actions. For one or more computer programs to be configured to perform particular operations or actions means that the one or more programs include instructions that, when executed by data processing apparatus, cause the apparatus to perform the operations or actions.

Embodiments of the subject matter and the functional operations described in this specification can be implemented in digital electronic circuitry, in tangibly-embodied computer software or firmware, in computer hardware, including the structures disclosed in this specification and their structural equivalents, or in combinations of one or more of them. Embodiments of the subject matter described in this specification can be implemented as one or more computer programs, i.e., one or more modules of computer program instructions encoded on a tangible non transitory storage medium for execution by, or to control the operation of, data processing apparatus. The computer storage medium can be a machine-readable storage device, a machine-readable storage substrate, a random or serial access memory device, or a combination of one or more of them. Alternatively or in addition, the program instructions can be encoded on an artificially generated propagated signal, e.g., a machine-generated electrical, optical, or electromagnetic signal, that is generated to encode information for transmission to suitable receiver apparatus for execution by a data processing apparatus.

The term "data processing apparatus" refers to data processing hardware and encompasses all kinds of apparatus, devices, and machines for processing data, including by way of example a programmable processor, a computer, or multiple processors or computers. The apparatus can also be, or further include, special purpose logic circuitry, e.g., an FPGA (field programmable gate array) or an ASIC (application specific integrated circuit). The apparatus can optionally include, in addition to hardware, code that creates an execution environment for computer programs, e.g., code that constitutes processor firmware, a protocol stack, a database management system, an operating system, or a combination of one or more of them.

A computer program, which may also be referred to or described as a program, software, a software application, an app, a module, a software module, a script, or code, can be written in any form of programming language, including compiled or interpreted languages, or declarative or procedural languages; and it can be deployed in any form, including as a stand alone program or as a module, component, subroutine, or other unit suitable for use in a computing environment. A program may, but need not, correspond to a file in a file system. A program can be stored in a portion of a file that holds other programs or data, e.g., one or more scripts stored in a markup language document, in a single file dedicated to the program in question, or in multiple coordinated files, e.g., files that store one or more modules, sub programs, or portions of code. A computer program can be deployed to be executed on one computer or on multiple computers that are located at one site or distributed across multiple sites and interconnected by a data communication network.

In this specification, the term "database" is used broadly to refer to any collection of data: the data does not need to be structured in any particular way, or structured at all, and it can be stored on storage devices in one or more locations. Thus, for example, the index database can include multiple collections of data, each of which may be organized and accessed differently.

Similarly, in this specification the term "engine" is used broadly to refer to a software-based system, subsystem, or process that is programmed to perform one or more specific functions. Generally, an engine will be implemented as one or more software modules or components, installed on one or more computers in one or more locations. In some cases, one or more computers will be dedicated to a particular engine; in other cases, multiple engines can be installed and running on the same computer or computers.

The processes and logic flows described in this specification can be performed by one or more programmable computers executing one or more computer programs to perform functions by operating on input data and generating output. The processes and logic flows can also be performed by special purpose logic circuitry, e.g., an FPGA or an ASIC, or by a combination of special purpose logic circuitry and one or more programmed computers.

Computers suitable for the execution of a computer program can be based on general or special purpose microprocessors or both, or any other kind of central processing unit. Generally, a central processing unit will receive instructions and data from a read only memory or a random access memory or both. The essential elements of a computer are a central processing unit for performing or executing instructions and one or more memory devices for storing instructions and data. The central processing unit and the memory can be supplemented by, or incorporated in, special purpose logic circuitry. Generally, a computer will also include, or be operatively coupled to receive data from or transfer data to, or both, one or more mass storage devices for storing data, e.g., magnetic, magneto optical disks, or optical disks. However, a computer need not have such devices. Moreover, a computer can be embedded in another device, e.g., a mobile telephone, a personal digital assistant (PDA), a mobile audio or video player, a game console, a Global Positioning System (GPS) receiver, or a portable storage device, e.g., a universal serial bus (USB) flash drive, to name just a few.

Computer readable media suitable for storing computer program instructions and data include all forms of non-volatile memory, media and memory devices, including by way of example semiconductor memory devices, e.g., EPROM, EEPROM, and flash memory devices; magnetic disks, e.g., internal hard disks or removable disks; magneto optical disks; and CD ROM and DVD-ROM disks.

To provide for interaction with a user, embodiments of the subject matter described in this specification can be implemented on a computer having a display device, e.g., a CRT (cathode ray tube) or LCD (liquid crystal display) monitor, for displaying information to the user and a keyboard and a pointing device, e.g., a mouse or a trackball, by which the user can provide input to the computer. Other kinds of devices can be used to provide for interaction with a user as well; for example, feedback provided to the user can be any form of sensory feedback, e.g., visual feedback, auditory feedback, or tactile feedback; and input from the user can be received in any form, including acoustic, speech, or tactile input. In addition, a computer can interact with a user by sending documents to and receiving documents from a device that is used by the user; for example, by sending web pages to a web browser on a user's device in response to requests received from the web browser. Also, a computer can interact with a user by sending text messages or other forms of message to a personal device, e.g., a smartphone that is running a messaging application, and receiving responsive messages from the user in return.

Data processing apparatus for implementing machine learning models can also include, for example, special-purpose hardware accelerator units for processing common and compute-intensive parts of machine learning training or production, i.e., inference, workloads.

Machine learning models can be implemented and deployed using a machine learning framework, .e.g., a TensorFlow framework, a Microsoft Cognitive Toolkit framework, an Apache Singa framework, or an Apache MXNet framework.

Embodiments of the subject matter described in this specification can be implemented in a computing system that includes a back end component, e.g., as a data server, or that includes a middleware component, e.g., an application server, or that includes a front end component, e.g., a client computer having a graphical user interface, a web browser, or an app through which a user can interact with an implementation of the subject matter described in this specification, or any combination of one or more such back end, middleware, or front end components. The components of the system can be interconnected by any form or medium of digital data communication, e.g., a communication network. Examples of communication networks include a local area network (LAN) and a wide area network (WAN), e.g., the Internet.

The computing system can include clients and servers. A client and server are generally remote from each other and typically interact through a communication network. The relationship of client and server arises by virtue of computer programs running on the respective computers and having a client-server relationship to each other. In some embodiments, a server transmits data, e.g., an HTML page, to a user device, e.g., for purposes of displaying data to and receiving user input from a user interacting with the device, which acts as a client. Data generated at the user device, e.g., a result of the user interaction, can be received at the server from the device.

## Claims

1. A computer-implemented method of using an environment model to simulate state transitions of a real-world environment being interacted with by a mechanical or electronic agent that is controlled using a policy neural network, wherein the policy neural network is configured to receive an observation characterizing a state of the environment, update a belief representation of the state of the environment, generate a latent representation from the belief representation, and generate an output specifying an action to be performed by the agent from the latent representation, and wherein the method comprises:
initializing an internal representation of a state of the environment at a current time point;
repeatedly performing the following operations:
receiving an action to be performed by the agent;
generating, based on the internal representation, a predicted latent representation that is a prediction of a latent representation that would have been generated by the policy neural network by processing an observation characterizing the state of the environment corresponding to the internal representation; and
updating the internal representation to simulate a state transition caused by the agent performing the received action by processing the predicted latent representation and the received action using the environment model;
selecting, based on a result of repeatedly performing the operations, the action to be performed by the agent in the environment at the current time point and causing the agent to perform the action.

2. The method of claim 1, further comprising:
generating, from the internal representation of the state of the environment, a target to be provided for use in controlling the agent.

3. The method of any one of claims 1-2, wherein initializing an internal representation of a state of the environment at a current time point comprises:
receiving, by the policy neural network, an observation characterizing the state of the environment at the current time point;
updating, by the policy neural network and based on processing the received observation, a belief representation of the state of the environment; and
initializing the internal representation based on the belief representation of the state of the environment.

4. The method of any one of claims 1-3, wherein updating the internal representation does not include processing the observation to be provided to the policy neural network that characterizes the state of the environment.

5. The method of any one of claims 1-4, further comprising:
processing, by the policy neural network, the belief representation of the state of the environment and the action that is performed by the agent to update the belief representation of the state of the environment at a future time point that is after the current time point.

6. The method of claim 5, wherein updating the belief representation of the state of the environment at the future time point further comprises processing an observation that characterizes the state of the environment at the future time point.

7. The method of any one of claims 1-6, wherein the latent representation corresponds to one or more layers of the policy neural network after updating the belief representation of the state of the environment; and optionally wherein the one or more layers comprise an input layer of the policy neural network after updating the belief representation of the state of the environment.

8. The method of any one of claims 1-6, wherein the latent representation corresponds to respective probabilities generated by the policy neural network for controlling the agent to perform different actions.

9. The method of any one of claims 1-6, wherein the latent representation corresponds to an intended action to be performed by the agent before selecting actions under exploration.

10. The method of any one of claims 1-9, wherein the policy neural network and the environment model are each a respective neural network having a plurality of network parameters; and optionally wherein the policy neural network and the environment model are each a recurrent neural network.

11. The method of any one of claims 1-10, wherein the environment specified in the latent representation of the state of the environment corresponds to a partial view of the environment being interacted with by the agent.

12. The method of any one of claims 1-11, wherein:
generating the latent representation from the belief representation comprises:
sampling from a distribution of a plurality of variables that describe the latent representation, the distribution being generated by the policy neural network and being conditioned on the belief representation; and
generating the predicted latent representation that is a prediction of the latent representation comprises:
sampling from a distribution of a plurality of variables that describe the latent representation, the distribution being generated by the environment model and being conditioned on the internal representation.

13. The method of any one of claims 1-12, further comprising:
iteratively training the environment model on training data to determine trained values of the model parameters, wherein the training data includes observation received by the agent during interaction with the environment; and optionally wherein training the environment model comprises, at each training iteration:
generating, by the environment model, a training predicted latent representation;
evaluating an objective function measuring a difference between the training predicted latent representation and the actual latent representation that is generated by the policy neural network; and
updating, based on a computed gradient of the objective function, corresponding values of the environment model parameters.

14. A system comprising one or more computers and one or more storage devices storing instructions that are operable, when executed by the one or more computers, to cause the one or more computers to perform the operations of the respective method of any preceding claim.

15. A computer storage medium encoded with instructions that, when executed by one or more computers, cause the one or more computers to perform the operations of the respective method of any one of claims 1-13.

## Patentansprüche

1. Computerimplementiertes Verfahren zum Verwenden eines Umgebungsmodells zum Simulieren von Zustandsübergängen einer realen Umgebung, mit der ein mechanischer oder elektronischer Agent interagiert, der unter Verwendung eines neuronalen Richtliniennetzes gesteuert wird, wobei das neuronale Richtliniennetz dazu konfiguriert ist, eine Beobachtung zu empfangen, die einen Zustand der Umgebung kennzeichnet, eine Glaubensdarstellung des Zustands der Umgebung zu aktualisieren, eine latente Darstellung der Glaubensdarstellung zu erzeugen und eine Ausgabe zu erzeugen, die eine durch den Agenten durchzuführende Aktion aus der latenten Darstellung spezifiziert, und wobei das Verfahren Folgendes umfasst:
Initialisieren einer internen Darstellung eines Zustands der Umgebung zu einem aktuellen Zeitpunkt;
wiederholtes Durchführen der folgenden Vorgänge:
Empfangen einer durch den Agenten durchzuführenden Aktion;
Erzeugen einer vorhergesagten latenten Darstellung, die eine Vorhersage einer latenten Darstellung ist, die durch das neuronale Richtliniennetz durch Verarbeiten einer Beobachtung, die den Zustand der Umgebung entsprechend der internen Darstellung kennzeichnet, erzeugt worden wäre, basierend auf der internen Darstellung; und
Aktualisieren der internen Darstellung, um einen Zustandsübergang zu simulieren, der durch den Agenten, der die empfangene Aktion durchführt, verursacht wird, indem die vorhergesagte latente Darstellung und die empfangene Aktion unter Verwendung des Umgebungsmodells verarbeitet werden;
Auswählen der durch den Agenten durchzuführenden Aktion in der Umgebung zum aktuellen Zeitpunkt basierend auf einem Ergebnis des wiederholten Durchführens der Vorgänge und Veranlassen des Agenten, die Aktion durchzuführen.

2. Verfahren nach Anspruch 1, ferner umfassend:
Erzeugen eines Ziels, das zur Verwendung beim Steuern des Agenten bereitgestellt wird, aus der internen Darstellung des Zustands der Umgebung.

3. Verfahren nach einem der Ansprüche 1-2, wobei das Initialisieren einer internen Darstellung eines Zustands der Umgebung zu einem aktuellen Zeitpunkt Folgendes umfasst:
Empfangen einer Beobachtung, die den Zustand der Umgebung zum aktuellen Zeitpunkt **kennzeichnet, durch** das neuronale Richtliniennetz;
Aktualisieren einer Glaubensdarstellung des Zustands der Umgebung **durch** das neuronale Richtliniennetz und basierend auf dem Verarbeiten der empfangenen Beobachtung; und
Initialisieren der internen Darstellung basierend auf der Glaubensdarstellung des Zustands der Umgebung.

4. Verfahren nach einem der Ansprüche 1-3, wobei das Aktualisieren der internen Darstellung nicht das Verarbeiten der Beobachtung beinhaltet, die dem neuronalen Richtliniennetz zur Verfügung gestellt wird, das den Zustand der Umgebung kennzeichnet.

5. Verfahren nach einem der Ansprüche 1-4, ferner umfassend:
Verarbeiten der Glaubensdarstellung des Zustands der Umgebung und der durch den Agenten durchgeführten Aktion, um die Glaubensdarstellung des Zustands der Umgebung zu einem zukünftigen Zeitpunkt der nach dem aktuellen Zeitpunkt liegt, zu aktualisieren, durch das neuronale Richtliniennetz.

6. Verfahren nach Anspruch 5, wobei das Aktualisieren der Glaubensdarstellung des Zustands der Umgebung zu dem zukünftigen Zeitpunkt ferner das Verarbeiten einer Beobachtung umfasst, die den Zustand der Umgebung zu dem zukünftigen Zeitpunkt kennzeichnet.

7. Verfahren nach einem der Ansprüche 1-6, wobei die latente Darstellung einer oder mehreren Schichten des neuronalen Richtliniennetzes nach dem Aktualisieren der Glaubensdarstellung des Zustands der Umgebung entspricht; und wobei optional die eine oder mehreren Schichten eine Eingabeschicht des neuronalen Richtliniennetzes nach dem Aktualisieren der Glaubensdarstellung des Zustands der Umgebung umfassen.

8. Verfahren nach einem der Ansprüche 1-6, wobei die latente Darstellung den jeweiligen Wahrscheinlichkeiten entspricht, die von dem neuronalen Richtliniennetz zur Steuerung des Agenten zum Durchführen unterschiedlicher Aktionen erzeugt werden.

9. Verfahren nach einem der Ansprüche 1-6, wobei die latente Darstellung einer beabsichtigten Aktion entspricht, die durch den Agenten vor dem Auswählen von Aktionen im Rahmen der Exploration durchzuführen ist.

10. Verfahren nach einem der Ansprüche 1-9, wobei das neuronale Richtliniennetz und das Umgebungsmodell jeweils ein neuronales Netz sind, das eine Vielzahl von Netzwerkparametern aufweist, und wobei das neuronale Netz und das Umgebungsmodell optional jeweils ein rekurrentes neuronales Netz sind.

11. Verfahren nach einem der Ansprüche 1-10, wobei die in der latenten Darstellung des Zustands der Umgebung spezifizierte Umgebung einer Teilansicht der Umgebung entspricht, mit der der Agent interagiert.

12. Verfahren nach einem der Ansprüche 1-11, wobei:
das Erzeugen der latenten Darstellung aus der Glaubensdarstellung Folgendes umfasst:
Abtasten aus einer Verteilung einer Vielzahl von Variablen, die die latente Darstellung beschreibt, wobei die Verteilung von dem neuronalen Richtliniennetz erzeugt wird, und durch die Glaubensdarstellung konditioniert ist; und
Erzeugen der vorhergesagten latenten Darstellung, die eine Vorhersage der latenten Darstellung ist,Folgendes umfasst:
Abtasten einer Verteilung einer Vielzahl von Variablen, die die latente Darstellung beschreibt, wobei die Verteilung durch das Umgebungsmodell erzeugt ist und durch die interne Darstellung konditioniert ist.

13. Verfahren nach einem der Ansprüche 1-12, ferner umfassend: iteratives Trainieren des Umgebungsmodells anhand von Trainingsdaten, um trainierte Werte der Modellparameter zu bestimmen, wobei die Trainingsdaten eine durch den Agenten während der Interaktion mit der Umgebung empfangene Beobachtung beinhalten; und wobei das Trainieren des Umgebungsmodells optional in jeder Trainingsiteration Folgendes umfasst:
Erzeugen einer trainierten vorhergesagten latenten Darstellung durch das Umgebungsmodell;
Bewerten einer Zielfunktion, die einen Unterschied zwischen der trainierten vorhergesagten latenten Darstellung und der tatsächlichen latenten Darstellung, die von dem neuronalen Richtliniennetz erzeugt wird, misst; und
Aktualisieren entsprechender Werte der Umgebungsmodellparameter basierend auf einem berechneten Gradienten der Zielfunktion.

14. System, umfassend einen oder mehrere Computer und eine oder mehrere Speichervorrichtungen, der/die Anweisungen speichert/speichern, die betriebswirksam sind, wenn sie von dem einen oder den mehreren Computern ausgeführt werden, den einen oder die mehreren Computer dazu veranlassen, die Vorgänge des jeweiligen Verfahrens nach einem der vorhergehenden Ansprüche durchzuführen.

15. Computerspeichermedium, das mit Anweisungen codiert ist, die bei Ausführung durch einen oder mehrere Computer den einen oder die mehreren Computer dazu veranlassen, die Vorgänge des jeweiligen Verfahrens nach einem der Ansprüche 1-13 durchzuführen.

## Revendications

1. Procédé mis en œuvre par ordinateur permettant d'utiliser un modèle d'environnement pour simuler des transitions d'état d'un environnement du monde réel avec lequel interagit un agent mécanique ou électronique qui est commandé à l'aide d'un réseau neuronal de politique, dans lequel le réseau neuronal de politique est configuré pour recevoir une observation caractérisant un état de l'environnement, mettre à jour une représentation de croyance de l'état de l'environnement, générer une représentation latente à partir de la représentation de croyance, et générer une sortie spécifiant une action à réaliser par l'agent à partir de la représentation latente, et dans lequel le procédé comprend :
l'initialisation d'une représentation interne d'un état de l'environnement à un moment actuel ;
la réalisation de manière répétée des opérations suivantes :
la réception d'une action à réaliser par l'agent ;
la génération, sur la base de la représentation interne, d'une représentation latente prédite qui est une prédiction d'une représentation latente qui aurait été générée par le réseau neuronal de politique en traitant une observation caractérisant l'état de l'environnement correspondant à la représentation interne ; et
la mise à jour de la représentation interne pour simuler une transition d'état provoquée par l'agent réalisant l'action reçue en traitant la représentation latente prédite et l'action reçue à l'aide du modèle d'environnement;
la sélection, sur la base d'un résultat de la réalisation de manière répétée des opérations, de l'action à réaliser par l'agent dans l'environnement au moment actuel et le fait d'amener l'agent à réaliser l'action.

2. Procédé selon la revendication 1, comprenant également :
la génération, à partir de la représentation interne de l'état de l'environnement, d'une cible à fournir pour être utilisée dans la commande de l'agent.

3. Procédé selon l'une quelconque des revendications 1 et 2, dans lequel l'initialisation d'une représentation interne d'un état de l'environnement à un moment actuel comprend :
la réception, par le réseau neuronal de politique, d'une observation caractérisant l'état de l'environnement au moment actuel ;
la mise à jour, par le réseau neuronal de politique et sur la base du traitement de l'observation reçue, d'une représentation de croyance de l'état de l'environnement ; et
l'initialisation de la représentation interne sur la base de la représentation de croyance de l'état de l'environnement.

4. Procédé selon l'une quelconque des revendications 1 à 3, dans lequel la mise à jour de la représentation interne ne comporte pas le traitement de l'observation à fournir au réseau neuronal de politique qui caractérise l'état de l'environnement.

5. Procédé selon l'une quelconque des revendications 1 à 4, comprenant également :
le traitement, par le réseau neuronal de politique, de la représentation de croyance de l'état de l'environnement et de l'action qui est réalisée par l'agent pour mettre à jour la représentation de croyance de l'état de l'environnement à un moment futur qui se situe après le moment actuel.

6. Procédé selon la revendication 5, dans lequel la mise à jour de la représentation de croyance de l'état de l'environnement au moment futur comprend également le traitement d'une observation qui caractérise l'état de l'environnement au moment futur.

7. Procédé selon l'une quelconque des revendications 1 à 6, dans lequel la représentation latente correspond à une ou plusieurs couches du réseau neuronal de politique après la mise à jour de la représentation de croyance de l'état de l'environnement ; et éventuellement dans lequel les une ou plusieurs couches comprennent une couche d'entrée du réseau neuronal de politique après la mise à jour de la représentation de croyance de l'état de l'environnement.

8. Procédé selon l'une quelconque des revendications 1 à 6, dans lequel la représentation latente correspond aux probabilités respectives générées par le réseau neuronal de politique pour commander l'agent afin de réaliser différentes actions.

9. Procédé selon l'une quelconque des revendications 1 à 6, dans lequel la représentation latente correspond à une action prévue devant être réalisée par l'agent avant de sélectionner les actions en cours d'exploration.

10. Procédé selon l'une quelconque des revendications 1 à 9, dans lequel le réseau neuronal de politique et le modèle d'environnement sont chacun un réseau neuronal respectif présentant une pluralité de paramètres réseau ; et éventuellement dans lequel le réseau neuronal de politique et le modèle d'environnement sont chacun un réseau neuronal récurrent.

11. Procédé selon l'une quelconque des revendications 1 à 10, dans lequel l'environnement spécifié dans la représentation latente de l'état de l'environnement correspond à une vue partielle de l'environnement avec lequel l'agent interagit.

12. Procédé selon l'une quelconque des revendications 1 à 11, dans lequel :
la génération de la représentation latente à partir de la représentation de croyance comprend :
l'échantillonnage à partir d'une distribution d'une pluralité de variables qui décrivent la représentation latente, la distribution étant générée par le réseau neuronal de politique et étant conditionnée par la représentation de croyance ; et
la génération de la représentation latente prédite qui est une prédiction de la représentation latente comprend :
l'échantillonnage à partir d'une distribution d'une pluralité de variables décrivant la représentation latente, la distribution étant générée par le modèle d'environnement et étant conditionnée par la représentation interne.

13. Procédé selon l'une quelconque des revendications 1 à 12, comprenant également :
l'entraînement de manière itérative du modèle d'environnement sur des données d'entraînement pour déterminer des valeurs entraînées des paramètres de modèle, dans lequel les données d'entraînement comportent une observation reçue par l'agent pendant l'interaction avec l'environnement ; et éventuellement dans lequel l'entraînement du modèle d'environnement comprend, à chaque itération d'entraînement :
la génération, par le modèle d'environnement, d'une représentation latente prédite par l'entraînement ;
l'évaluation d'une fonction objective mesurant une différence entre la représentation latente prédite par l'entraînement et la représentation latente réelle qui est générée par le réseau neuronal de politique ; et
la mise à jour, sur la base d'un gradient calculé de la fonction objective, de valeurs correspondantes des paramètres de modèle d'environnement.

14. Système comprenant un ou plusieurs ordinateurs et un ou plusieurs dispositifs de stockage stockant des instructions qui permettent, lorsqu'elles sont exécutées par les un ou plusieurs ordinateurs, d'amener les un ou plusieurs ordinateurs à réaliser les opérations du procédé respectif selon une quelconque revendication précédente.

15. Support de stockage informatique codé avec des instructions qui, lorsqu'elles sont exécutées par un ou plusieurs ordinateurs, amènent les un ou plusieurs ordinateurs à réaliser les opérations du procédé respectif selon l'une quelconque des revendications 1 à 13.
